# FASCICULE DE BREVET EUROPEEN

(11) **EP 3 031 087 B1**
(45) Date de publication et mention de la délivrance du brevet: **07.11.2018**
(21) Numéro de dépôt: 14790162.3
(22) Date de dépôt: 31.07.2014
(51) Int. Cl.: H01L 51/10, H01L 27/28

(54) **PROCEDE DE FABRICATION D'UN CIRCUIT CMOS ORGANIQUE ET CIRCUIT CMOS ORGANIQUE PROTEGE CONTRE LES UV**
VERFAHREN ZUR HERSTELLUNG EINER ORGANISCHEN CMOS-SCHALTUNG UND ORGANISCHE CMOS-SCHALTUNG MIT SCHUTZ VOR UV-STRAHLUNG
METHOD FOR PRODUCING AN ORGANIC CMOS CIRCUIT AND ORGANIC CMOS CIRCUIT PROTECTED AGAINST UV RADIATION

(30) Priorité: 08.08.2013 FR 1357883
(43) Date de publication de la demande: 15.06.2016
(73) Titulaire: Commissariat à l'Énergie Atomique et aux Énergies Alternatives, 75015 Paris (FR)
(72) Inventeur: BENWADIH, Mohammed, 94500 Champagny Sur Marne (FR); COPPARD, Romain, 38500 Voiron (FR); PONCELET, Olivier, 38000 Grenoble (FR)
(74) Mandataire: Cabinet Laurent & Charras
(86) Numéro de dépôt international: PCT/FR2014/051993
(87) Numéro de publication internationale: WO 2015/019004

(56) Documents cités:
- US-A1- 2010 127 241
- US-A1- 2011 115 101
- JUI-FEN CHANG ET AL: "Conjugated-Polymer-Based Lateral Heterostructures Defined by High-Resolution Photolithography", ADVANCED FUNCTIONAL MATERIALS, WILEY - V C H VERLAG GMBH & CO. KGAA, DE, vol. 20, no. 17, 9 septembre 2010 (2010-09-09), pages 2825-2832, XP001557003, ISSN: 1616-301X, DOI: 10.1002/ADFM.201000436
- YANG F Y ET AL: "High-performance poly(3-hexylthiophene) top-gate transistors incorporating TiO2 nanocomposite dielectrics", ORGANIC ELECTRONICS, ELSEVIER, AMSTERDAM, NL, vol. 11, no. 1, 1 janvier 2010 (2010-01-01), pages 81-88, XP026817218, ISSN: 1566-1199 [extrait le 2009-10-13]
- MIN HEE LEE ET AL: "The Effect of SiO 2 Shell on the Suppression of Photocatalytic Activity of TiO 2 and ZnO Nanoparticles", BULLETIN OF THE KOREAN CHEMICAL SOCIETY, vol. 33, no. 11, 20 novembre 2012 (2012-11-20), pages 3767-3771, XP055096257, ISSN: 0253-2964, DOI: 10.5012/bkcs.2012.33.11.3767
- TANG ET AL: "Fabrication of zinc oxide/poly(styrene) grafted nanocomposite latex and its dispersion", EUROPEAN POLYMER JOURNAL, PERGAMON PRESS LTD. OXFORD, GB, vol. 43, no. 10, 28 septembre 2007 (2007-09-28), pages 4210-4218, XP022277511, ISSN: 0014-3057, DOI: 10.1016/J.EURPOLYMJ.2007.05.015

## Description

### DOMAINE DE L'INVENTION

L'invention se rapporte aux circuits CMOS organiques, notamment à la fabrication de ceux-ci.

### ETAT DE LA TECHNIQUE

Les circuits CMOS organiques comprennent usuellement un transistor MOS organique de type N et un transistor MOS organique de type P, partageant une grille commune ainsi qu'un drain et une source commune. Si la technologie organique offre un certain nombre d'avantages, par exemple en termes de coût de fabrication, les matériaux semi-conducteurs entrant dans la constitution des transistors se dégradent cependant sous l'effet de rayonnements ultraviolets qui cassent leurs chaines organiques, et par conséquent les liaisons électroniques induisant l'effet semi-conducteur. Par exemple, une exposition à un fort rayonnement ultraviolet détruit en grande partie l'effet semi-conducteur d'un matériau semi-conducteur organique de type N, le rapport Ion/Ioff entre le courant en mode passant Ion et le courant à l'état bloqué Ioff d'un transistor organique de type N passant de -6 décades à -1 décade, rendant de ce fait le transistor non fonctionnel.

Un circuit CMOS peut subir un premier rayonnement ultraviolet (UV) lors de sa fabrication en raison des techniques de fabrication employées, et un second type de rayonnement ultraviolet lors de son utilisation, par exemple les ultraviolets solaires.

D'une manière générale, pour fabriquer un élément semi-conducteur sur une face d'un support, une couche de matériau semi-conducteur est tout d'abord déposée sur l'ensemble de ladite face, puis une gravure est mise en oeuvre pour éliminer le matériau semi-conducteur en excès afin de le laisser uniquement l'élément semi-conducteur souhaité. Or, certaines gravures, notamment les gravures au plasma consistant à bombarder le matériau à retirer à l'aide d'un gaz ionisé, génère une forte quantité de rayonnements ultraviolets et ne sont donc pas appropriées pour définir un élément semi-conducteur organique.

Par ailleurs, lors de la vie d'un circuit CMOS, ce dernier est sujet à des rayonnements ultraviolets, notamment d'origine solaire, et sans mesure particulière, on observe une dégradation des matériaux semi-conducteurs entrant dans la constitution du circuit CMOS.

Un circuit CMOS comprenant un transistor organique de type N et un transistor organique de type P est notamment décrit dans l'article « Conjugated-Polymer-Based Latéral Heterostructures Defined by High-Resolution Photolithography », Jui-Fen Chang et al., Advanced Functional Materials, 20, 2825 (2010). L'article « High-performance poly(3-hexylthiophene) top-gate transistors incorporating TiO2 nanocomposite dielectrics », Peng-Yu Yang et al., Organic Electronics, 11, 81 (2010) décrit un transistor organique ayant une couche de protection comportant des nanoparticules de TiO₂.

### EXPOSE DE L'INVENTION

Un but de l'invention est de proposer un circuit CMOS de sensibilité réduite au rayonnement UV.

A cet effet, l'invention a pour objet un circuit CMOS organique comprenant un substrat sur lequel sont formés un transistor organique de type N et un transistor organique de type P, partageant par exemple un grille commune ainsi qu'un drain commun, lesdits transistors comportant respectivement une couche de matériau semi-conducteur de type N et une couche de matériau semi-conducteur de type P. Selon l'invention, une face de chacune des couches semi-conducteur, opposée au substrat, est recouverte d'une couche anti-ultraviolet constituée de matériau électriquement isolant absorbant et/ou réfléchissant les rayonnements ultra-violets.

Un autre but de l'invention est de proposer un procédé de fabrication d'un circuit CMOS qui protège les matériaux semi-conducteurs constitutifs des transistors contre les UV au cours même de la fabrication.

A cet effet, un objet de l'invention concerne un procédé de fabrication d'un circuit CMOS organique comprenant un substrat sur lequel sont formés un transistor organique de type N et un transistor organique de type P, le procédé comportant :
▪ la réalisation de première, deuxième et troisième électrodes conductrices distinctes sur une face d'un support ;
▪ le dépôt sur l'ensemble de la face du support d'une première couche de matériau semi-conducteur organique d'un premier type de conductivité ;
▪ le retrait partiel de la première couche de matériau semi-conducteur de manière à conserver uniquement une première portion de matériau semi-conducteur recouvrant au moins partiellement la première électrode, au moins partiellement la deuxième électrode et une zone de la face du support reliant les première et deuxième électrodes ;
▪ le dépôt sur l'ensemble de la face du support d'une seconde couche de matériau semi-conducteur organique d'un second type de conductivité, opposé au premier type de conductivité ;
▪ le retrait partiel de la seconde couche de matériau semi-conducteur de manière à conserver uniquement une seconde portion recouvrant au moins partiellement la deuxième électrode, au moins partiellement la troisième électrode et une zone de la face du support reliant les deuxième et troisième électrodes.

Selon l'invention :
▪ préalablement au retrait partiel de la première couche de matériau semi-conducteur, une couche anti-ultraviolet constituée d'un matériau électriquement isolant absorbant et/ou réfléchissant les rayonnements ultra-violets est déposée sur la première portion de matériau semi-conducteur ; et
▪ préalablement au retrait partiel de la seconde couche de matériau semi-conducteur, une couche anti-ultraviolet constituée d'un matériau électriquement isolant absorbant et/ou réfléchissant les rayonnements ultra-violets est déposée sur la seconde portion de matériau semi-conducteur.

Selon un mode de réalisation, les couches anti-ultraviolet comprennent une matrice organique dans laquelle sont dispersées des particules de ZnO, de TiO₂, de CeO₂ et/ou d'organoclay. De telles particules absorbent fortement le rayonnement UV sur une large gamme de longueurs d'onde. Notamment, l'oxyde de zinc absorbe les UV entre 200 et 390 nanomètres. Les organoclay, tels que décrits par exemple dans la demande FR 2 925 518, bloquent quant à eux les UV au-delà de 390 nanomètres. La combinaison de particules de ZnO, de TiO₂, de CeO₂ avec des organoclay permet donc d'étendre la gamme de protection contre les UV. Par ailleurs, utiliser une matrice organique dans laquelle sont dispersées des particules, permet de contrôler l'adhérence de la couche de protection sur la couche de matériau semi-conducteur, et donc facilite le retrait des couches de protection si cela est souhaité.

De manière avantageuse, les particules sont enrobées de silice, ce qui permet d'éviter une photocatalyse des particules ultérieurement ou lors de la fabrication même du circuit CMOS. Non seulement, cela permet donc d'obtenir des particules stables dans le temps, et donc une fonction de blocage des rayonnements UV stable dans le temps, mais cela évite également que des produits issues de la photocatalyse n'interagissent avec les matériaux semi-conducteurs et dégradent donc ceux-ci.

De manière avantageuse, les particules ont leurs dimensions comprises entre 1 nanomètre et 200 nanomètres, et de préférence entre 20 nanomètres et 30 nanomètres. En limitant la taille des particules, on réduit ainsi le risque de formation d'agrégats. Les particules sont ainsi réparties de manière homogène dans les couches anti-UV.

De manière avantageuse, les particules représentent 45% à 55% de la masse des couches anti-ultraviolet, ce qui permet un dépôt aisé de la couche anti-UV, et limite donc le coût de fabrication du circuit CMOS.

De manière avantageuse, les couches anti-ultraviolet comprennent du latex de polystyrène et/ou l'acide pyrène carboxylique, ce qui protège les particules contre l'oxydation, et par conséquent évite que ces dernières perdent leur pourvoir anti-UV.

Selon un mode de réalisation, les couches anti-ultraviolet ont une épaisseur comprise entre 50 nanomètres et 800 nanomètres, et de préférence entre 100 nanomètres et 200 nanomètres. De telles épaisseurs offrent un bon compromis entre le fonctionnement des transistors, dont la qualité dépend de l'épaisseur de la couche isolante intercalée entre les électrodes de grille et les couches de matériaux semi-conducteur, et la protection contre les UV.

Selon un mode de réalisation, chaque transistor comprend une couche de matériau diélectrique intercalée entre la couche anti-ultraviolet recouvrant la couche de matériau semi-conducteur du transistor et une électrode de grille du transistor, et l'épaisseur totale de la couche diélectrique et de la couche anti-ultraviolet du transistor est inférieure à 1 micromètre. On observe en effet qu'au-delà d'une épaisseur totale de la couche isolante, les transistors présentent des caractéristiques médiocres.

Selon un mode de réalisation, la matrice organique est constitué d'un polymère fluoré, notamment de CYTOP.

Selon un mode de réalisation du procédé, les couches anti-ultraviolet présentent une épaisseur supérieure à 800 nanomètres, et les couches anti-ultraviolets sont ôtées après la finalisation des première et deuxième portions de matériau semi-conducteur. Une épaisseur importante permet en effet d'optimiser la protection contre les UV lors de la fabrication du circuit CMOS.

Selon un mode de réalisation du procédé, les retraits partiels des couches de matériau semi-conducteur sont réalisés au moyen d'une gravure au plasma, une telle technique convenant à présent pour la fabrication d'un circuit CMOS organique.

Selon un mode de réalisation, la couche anti-ultraviolet ne recouvre sensiblement que la couche semi-conducteur. Selon un mode de réalisation, les transistors comprennent des électrodes de grille transparente au rayonnement visible. La surface totale du circuit laissant passer la lumière, tout en obtenant une protection efficace des couches semi-conducteurs contre les UV, est ainsi maximisée.

### BREVE DESCRIPTION DES FIGURES

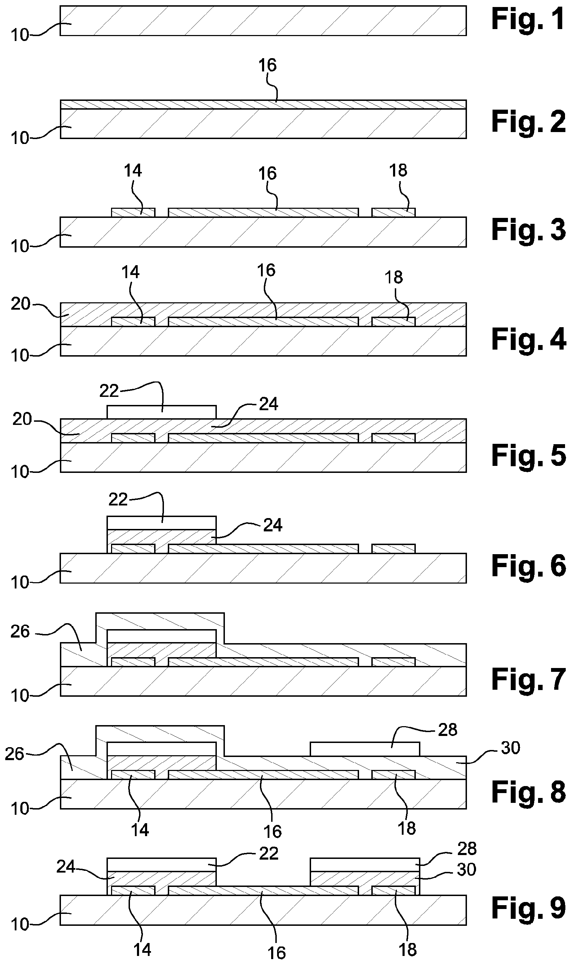

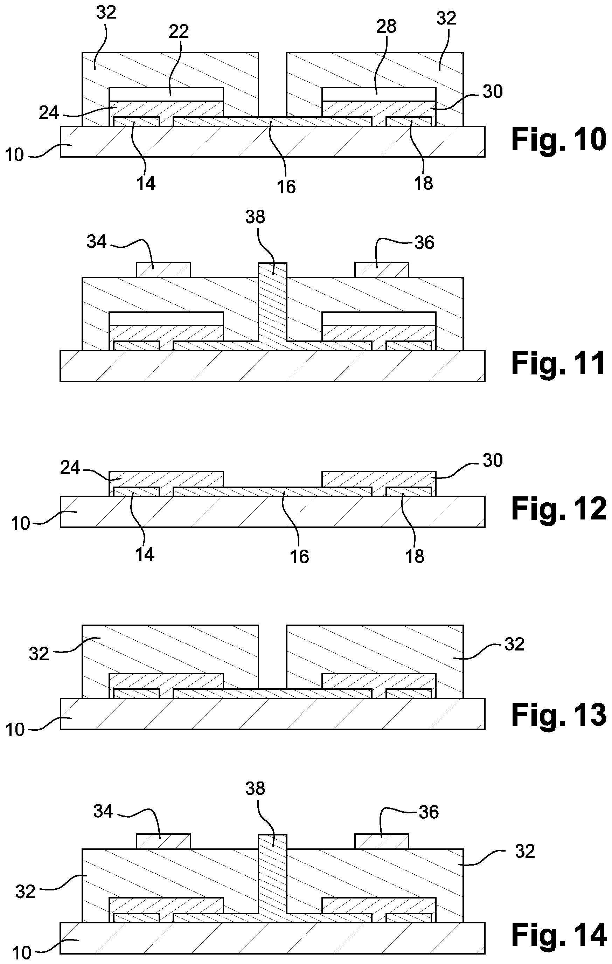

L'invention sera mieux comprise à la lecture de la description qui va suivre, donnée uniquement à titre d'exemple, et réalisée en relation avec les dessins annexés, dans lesquels des références identiques désignent des éléments identiques, et dans lesquels :
▪ les figures 1 à 11 sont des vues schématiques en coupe illustrant un procédé selon un premier mode de réalisation de l'invention ; et
▪ les figures 12 à 14 sont des vues schématique en coupe illustrant un procédé selon un second mode de réalisation selon l'invention.

### DESCRIPTION DETAILLEE DE L'INVENTION

Comme cela est connu en soi, un circuit CMOS comporte un transistor organique de type P et un transistor organique de type N partageant une grille commune, la source d'un transistor étant par ailleurs le drain de l'autre transistor, ou les transistors partageant un drain commun. Dans ce qui suit, il est décrit une topologie de transistor de type « grille haute ». Bien évidemment, l'invention s'applique à tout type de topologie, notamment une topologie de type « grille basse ». De même, il est décrit des électrodes communes aux deux transistors, ces électrodes consistant par exemple un seul élément qui remplit deux fonctions. On comprendra que l'invention s'applique également à tout type d'électrode et de schéma de connexion de celle-ci.

Il va à présent être décrit en relation avec les figures 1 à 11 un procédé de fabrication d'un circuit CMOS organique selon un premier mode de réalisation.

Le procédé débute (figure 1) par la réalisation d'un substrat **10** organique ou inorganique d'une épaisseur comprise entre 25 micromètres et 1 millimètre, en silice, en silicium, en téréphtalate de polyéthylène (PET), en naphtalate de polyéthyle (PEN), en polyimide (PI), en polyéther imide (PEI), en polyéther sulfone (PES), en polysulfone (PSF), en sulfure de polyphénylène (PPS), en polyéther éther cétone (PEEK), en polyacrylate (PA), en polyamide imide (PAI), en polystyrène, en polyéthylène, en polypropylène, en une résine polyamine, en une résine carbonate ou en une résine cellulosique. Par exemple, le substrat est constitué de PET ou de PEN d'une épaisseur comprise entre 100 micromètres et 150 micromètres, notamment 125 micromètres, ce qui permet de définir un substrat flexible et présentant une bonne tenue en température et une bonne tenue mécanique.

Le procédé se poursuit (figure 2) par le dépôt d'une couche en matériau conducteur **12** sur une épaisseur comprise entre 20 nanomètres et 100 nanomètres, de préférence 30 nanomètres, puis une gravure, par exemple chimique, est mise en oeuvre pour définir une première, deuxième et une troisième électrodes **14, 16, 18** définissant les électrodes de drain et de source de deux transistors organiques (figure 3). Le matériau constitutif des électrodes **14, 16, 18** est un métal, par exemple de l'or (Au), de l'agent (Ag), du cuivre (Cu), du nickel (Ni), du palladium (Pd), du platine (Pt), de l'aluminium (Al), du titane (Ti), du chrome (Cr), du molybdène (Mo), un polymère conducteur, par exemple du poly(3,4-éthylènedioxythiophène) (PEDOT) mélangé avec du poly(styrène sulfonate) de sodium (PSS), de la polyaniline (Pani), ou un oxyde métallique conducteur, par exemple de l'oxyde d'indium-étain (ITO), de l'oxyde de zinc enduit d'aluminium (AZO), du trioxyde de tungstène (WO₃).

De manière optionnelle, lorsque les électrodes sont constituées de métal, un matériau modifiant leur travail de sortie est par ailleurs déposé sur celles-ci afin d'améliorer l'injection de charges dans les matériaux semi-conducteurs avec lesquels elles seront ultérieurement en contact pour former des transistors.

Par exemple, la première électrode **14** et une portion de la deuxième électrode **16,** sur lesquelles est ultérieurement déposé un élément semi-conducteur de type N constitutif du transistor de type N, sont recouvertes d'une couche de quelques nanomètres de SAM (pour self assembled monolayer »), notamment de 4-(methylsulfanyl)-thiophenol (MeSTP), de 4-methoxythiophenol (MeOTP), de 4-methylthiophenol (MeTP), de 4-aminothiophenol (ATP), de 4-nitrothiophenol (NOTP), de cysteamine (CT), de 1-decanethiol (DT), de 1H,1H,2H,2H-perfluorodecanethiol (PFDT), ou de 1H,1H,2H,2H-perfluorooctanethiol (PFOT).

De même, la troisième électrode **18** et une portion de la deuxième électrode **14** sur lesquelles est ultérieurement déposé un élément semi-conducteur de type P constitutif d'un transistor de type P, sont recouvertes d'une couche de quelques nanomètres de SAM, notamment de perfluorobenzenethiol (PFBT).

De manière avantageuse, avant le dépôt des couches de SAM, le substrat **10** et les électrodes **14, 16, 18,** subissent un nettoyage améliorant la greffe des SAM sur les électrodes et l'adhérence du substrat vis-à-vis des matériaux semi-conducteurs ultérieurement déposés. Par exemple, le nettoyage est réalisé au moyen d'un plasma.

Dans une étape suivante, une couche de matériau semi-conducteur organique de type N **20** est déposée sur la totalité du support **10** et des électrodes **14, 16, 18** (figure 4). L'épaisseur de la couche de matériau semi-conducteur est de préférence comprise entre 70 nanomètres et 120 nanomètres afin de réduire, voire d'éviter, des résistances parasites dans les transistors organiques.

Le procédé se poursuit en suite par le dépôt d'un premier masque anti-UV **22** sur la couche de matériau semi-conducteur organique de type N **22,** la géométrie du masque correspondant à celle de l'élément semi-conducteur entrant dans la constitution du transistor organique de type N (figure 5). Le masque anti-UV **22** est constitué d'un matériau organique électriquement isolant et présentant par ailleurs un pouvoir réflecteur ou absorbant de rayonnement anti-UV qui protège contre les UV la portion de matériau semi-conducteur **24** sur laquelle il est déposé, comme cela sera expliqué plus en détail par la suite.

Une gravure est alors appliquée pour ôter la couche de matériau semi-conducteur de type N **20,** hormis la portion **24** sur laquelle est déposé le masque anti-UV **22** (figure 6). En raison de la présence de ce dernier, il est possible d'utiliser des gravures s'accompagnant d'émission d'UV, et compris d'émission élevée d'UV. Notamment, une gravure au plasma est mise en oeuvre, cette technique ayant l'avantage d'être une gravure sèche s'appliquant uniquement à la surface visée et permettant de graver orthogonalement la couche **20.** D'autres gravures sont cependant possibles, par exemple une gravure chimique.

Lors d'une étape suivante, une couche de matériau semi-conducteur de type P **26** est déposée sur la totalité de l'ensemble obtenu à l'étape précédente (figure 7). L'épaisseur de la couche **26** est comprise entre 70 nanomètres et 120 nanomètres afin de limiter les résistances parasites.

Un second masque anti-UV **28** est ensuite déposé sur la couche de matériau semi-conducteur organique de type P **26,** la géométrie du second masque **28** correspondant à celle de l'élément semi-conducteur entrant dans la constitution du transistor organique de type P (figure 8). Le second masque anti-UV **26** est constitué d'un matériau organique électriquement isolant et présentant par ailleurs un pouvoir réflecteur ou absorbant de rayonnement anti-UV qui protège contre les UV la portion de matériau semi-conducteur **26** sur laquelle il est déposé, comme cela sera expliqué plus en détail par la suite.

Une gravure est alors appliquée pour ôter la couche de matériau semi-conducteur de type P **26,** hormis la portion **30** sur laquelle est déposé le masque anti-UV **22** (figure 9). En raison de la présence de ce dernier, il est également possible d'utiliser des gravures s'accompagnant d'émission d'UV, et compris d'émission élevée d'UV. Notamment, une gravure au plasma est mise en oeuvre. D'autres gravures sont cependant possibles, par exemple une gravure chimique.

Dans une étape suivante, une couche de diélectrique organique **32** est formée de manière à isoler électriquement les portions de matériau semi-conducteur **24, 30** et à laisser dégagée une portion de la deuxième électrode **16** (figure 10). Par exemple, la couche de diélectrique est déposée sur le support **10,** les électrodes **14, 16, 18** et les ilots formés des portions de matériau semi-conducteur **24, 30** et des masques anti-UV **22, 28,** puis une portion de la couche diélectrique **32** est gravée de manière à dégager une portion de la deuxième électrode **16.** La couche diélectrique **32** est par exemple constituée d'un polymère fluoré, notamment de CYTOP, de polyvinylphénol (PVP), de polyméthacrylate de méthyle (PMMA) combiné ou non à de l'acrylate, de polystyrène ou de polyimide, et a une épaisseur comprise entre 500 nanomètres et 1 micromètre.

Enfin, le procédé se termine par le dépôt d'une première et d'une deuxième électrodes de grille conductrices **34, 36** sur la couche de diélectrique **32,** respectivement au-dessus des première et deuxièmes électrodes **14, 16** et au-dessus de la deuxième et troisième électrodes **16, 18,** d'une épaisseur comprise entre 30 nanomètres et 1 micromètre, et de préférence entre 50 nanomètres et 200 nanomètres, ainsi qu'une reprise de contact conductrice **38** avec la deuxième électrode **38.** Les électrodes **34, 38** et la reprise de contact **38** sont par exemple constituées d'un matériau décrit en relation avec les électrodes **14, 16, 18,** par exemple un matériau identique à celui des électrodes **14, 16, 18.**

Il est ainsi obtenu un circuit CMOS comprenant un transistor organique de type N, comportant ou constitué de la première et de la deuxième électrodes **14, 16** formant respectivement le drain et la source du transistor, de la portion semi-conductrice de type N **24,** de la couche diélectrique **32** et de la grille **34,** et un transistor organique de type P, comportant ou constitué de la deuxième et de la troisième électrode **16, 18,** formant respectivement la source et le drain du transistor, de la portion semi-conductrice de type P **30,** de la couche diélectrique **32** et de la grille **36.**

Les couches semi-conductrices organiques entrant dans la constitution des transistors N et P ont donc été protégées des UV lors de la fabrication du circuit et sont protégées au cours de l'utilisation du circuit par les masques anti-UV **22, 28.**

Le mode de réalisation venant d'être décrit présente en outre les avantages suivants :
- la présence des masques anti-UV **22, 28** dans le circuit CMOS permet en outre de s'affranchir d'une couche d'encapsulation supérieure anti-UV ;
- la possibilité d'utiliser une couches diélectriques et/ou des grilles transparentes, puisqu'une protection anti-UV est mise en oeuvre par les masques. Par exemple, les grilles peuvent présenter une épaisseur faible laissant passer une quantité importante de rayonnement visible, et manière incidente également une quantité importante d'UV. Ainsi pour certaine application, l'épaisseur et/ou le choix des matériaux de la grille sont choisies pour que ces dernières soient transparentes ;
- chaque masque anti-UV **22** et **28** est localisé uniquement sur la portion semi-conductrice correspondante **24, 30.** Une protection des portions semi-conductrices **24, 30** est ainsi obtenue tout en laissant passer la lumière au niveau des zones du circuit CMOS où il n'y a pas de protection anti-UV. La surface occupée par les masques anti-UV est ainsi réduite à son minimum. Le circuit CMOS peut ainsi par exemple être utilisé dans des applications nécessitant une transparente du circuit, comme par exemple dans une matrice active d'un écran ;
- les masques anti-UV **22, 28** sont formés directement au contact des couches semi-conductrices **22** et **28,** l'ordre de l'empilement des couches du circuit CMOS étant donc « couches semiconductrices/masques anti-UV/couche diélectrique ». Il a été en effet observé que réaliser un empilement ayant pour ordre « couches semi-conductrices/couche diélectrique/masques anti-UV » peut mener à un important courant de fuite lorsque les masques anti-UV est constitué d'une matrice dans laquelle sont dispersées des particules anti-UV. En effet, les particules peuvent former des agglomérats de particules présentant des pointes qui percent la couche diélectrique sous-jacente lors du dépôt des masques anti-UV, ce qui conduit à une mauvaise isolation électrique entre la grille et les couches semi-conductrice, et donc à un fort courant de fuite, voire même à un court-circuit ;
- les masques anti-UV forment également les masques pour la gravure, ce qui limite donc le nombre d'étapes de fabrication du circuit CMOS.

Il va à présent être décrit en relation avec les figures 12 à 14 un procédé selon un second mode de réalisation.

Les premières étapes du procédé selon le second mode de réalisation sont identiques ou analogues aux premières étapes du premier mode de réalisation décrites en relation avec les figures 1 à 9, l'épaisseur et la constitution des masques anti-UV **22** et **28** pouvant cependant varier de la manière décrite ci-dessous. Le second mode présente donc les avantages décrits ci-dessus en lien avec la gravure et la protection anti-UV lors de celle-ci.

Le procédé se poursuit par le retrait des masques **22** et **28** (figure 12). Ce retrait est réalisé par voie liquide par un solvant orthogonal aux couches actives du CMOS, c'est-à-dire un solvant non susceptible d'attaquer ou dissoudre ces dernières, tel que le cyclohexane ou tous les fluoro-solvant, ou par d'autres techniques telle que la gravure laser ou la gravure au plasma. Notamment, le choix du ou des matériaux pour les masques décrit ci-dessous permet un retrait aisé de ces masques ne laissant sensiblement aucun résidu sur les couches semi-conductrices, la qualité finale du circuit n'étant donc sensiblement par affectée par la présence de résidu.

La couche diélectrique **32** est ensuite déposée (figure 13) de manière analogue à l'étape décrite en relation avec la figure 10, puis les grilles **34, 36** et la reprise de contact **38** sont réalisée de manière analogue à l'étape décrite en relation avec la figure 11.

Le matériau semi-conducteur des portions **24, 30** est constitué de molécules de faible masse moléculaire, couramment appelées « petites molécules », et notamment de molécules de masse moléculaire inférieure à 1000 g/mol, ou de polymères constitués de macromolécules de plus grande masse moléculaire. Ces deux types de semi-conducteurs organiques ont pour point commun de présenter un système conjugué provenant de l'alternance de simples et de doubles liaisons carbone-carbone, et ainsi de présenter un effet semi-conducteur.

A titre d'exemples de matériaux semi-conducteurs organiques de faible masse moléculaire, on peut citer ceux de type polyacène, oligo-thiophène ou phtalocyanine.

A titre d'exemple de matériaux semi-conducteurs organiques polymères, on peut citer ceux de type polyacétylène, polyphénylène, polythiophène ou poly(phénylène/vinylène).

Il peut notamment s'agir d'un semi-conducteur organique choisi dans le groupe comprenant le pentacène, le tétracène, l'anthracène, le naphthalène, l'alpha-6-thiophène, l'alpha-4-thiophène, le pérylène et ses dérivés, le rubrène et ses dérivés, le coronène et ses dérivés, le diimide tétracarboxylique de pérylène et ses dérivés, le dianhydride tétracarboxylique de pérylène et ses dérivés, le polythiophène et ses dérivés, le polyparaphenylène-vinylène et ses dérivés, le polyparaphénylène et ses dérivés, le polyfluorène et ses dérivés, le copolymère, le polyfluorène-oligothiophène et ses dérivés, le polythiophène-vinylène et ses dérivés, un copolymère aromatique hétérocyclique de polythiophène et ses dérivés, le oligonaphthalène et ses dérivés, l'alpha-5-thiophène oligothiophène et ses dérivés, le phthalocyanine qui ne contient pas de métal et ses dérivés, le dianhydride pyromellitique et ses dérivés, le diimide pyromellitique et ses dérivés, le dianhydride d'acide tétracarboxylique de pérylène et ses dérivés, le diimide tétracarboxylique de pérylène et ses dérivés, le diimide tétracarboxylique de naphtalène et ses dérivés ou dianhydride-acide tétracarboxylique de naphtalène et ses dérivés.

Avantageusement, le matériau semi-conducteur organique de type P est choisi parmi le pentacène, le tétracène et l'anthracène, le Tips pentacène modifié, le polythiophène, P3HT (poly(3-hexylthiophène)), le PCDTBT (poly[N- 9'-heptadecanyl-2,7-carbazole-alt-5,5-(4,7-di-2-thienyl-2',1',3'-benzothiadiazole]), et est de préférence du pentacène.

Avantageusement, le matériau semi-conducteur organique de type N est choisi parmi le pérylène diimide, le fullerène, le PCBM ([6,6]-phényl-C₆₁-butyrate de méthyle), le PCNEPV (poly[oxa-1,4-phénylène-(1-cyano-1,2-vinylène)-(2-méthoxy-5-(3,7-diméthyl-octyloxy)-1,4-phénylène)-1,2-(2-cyanovinylène)-1,4-phénylène]), et le polyfluorène.

Les masques anti-UV **22, 30** sont quant à eux constitués d'une composition comprenant une matrice organique, notamment polymère, dans laquelle sont dispersées, ou sur laquelle sont déposées, des particules qui bloquent les UV par absorption ou réflexion. La matrice dans laquelle sont dispersées les particules, est par exemple déposée par une technique du type « sol-gel », une technique de dépôt sous vide, une technique de pulvérisation cathodique, par une technique de dépôt à la tournette, une technique de dépôt au couteau, ou autres.

La matrice organique est avantageusement constituée d'un polymère n'ayant pas d'affinité avec les matériaux semi-conducteurs constitutifs des transistors et par conséquent ne détériorant pas ces derniers. De plus, dans le cadre du mode de réalisation dans lequel les masques **22, 30** sont retirés, la matrice est également choisie pour pouvoir être facilement retirée par gravure sans induire la gravure des portions semi-conductrices **24, 30** sur lesquelles elles sont déposées. A cet effet, la matrice des masques anti-UV **22, 30** est constituée d'un polymère fluoré, notamment du CYTOP, qui n'a pas d'affinité chimique avec les matériaux semi-conducteurs organiques usuels, et pouvant être gravé par un solvant dit « orthogonal », tel que l'acétate de butyle, l'acétate d'éthyle ou l'acétate de méthyle, qui ne détériore pas non plus les matériaux semi-conducteurs organiques.

D'autres polymères sont également possibles, comme par exemple des polymères vinyliques, notamment le polystyrène, qui peuvent être gravés par un solvant comme l'acétate d'éthyle.

Les particules bloquant les UV sont quant à elles des particules de ZnO, de TiO₂, et/ou de CeO₂. En variante, ou de manière supplémentaire, des pigments organiques anti-UV tels que décrits dans la demande FR 2 955 115 sont dispersés dans la matrice organique.

De manière avantageuse, des particules d'organoclay sont également dispersées dans, ou déposées sur la matrice, de manière à étendre la gamme d'UV bloqués. Les organoclays comprennent en effet du pyrène et/ou du phénylhydroxybenzotriazole qui bloquent les UV jusqu'à 400 nanomètres de longueur d'onde. Les organoclay présentent l'avantage de minimiser les défauts électriques, les pièges notamment.

Les organoclays sont par exemple décrits dans la demande FR 2 925 518. Une combinaison de particules de ZnO et de particules d'organoclay permet ainsi de bloquer les UV dans la gamme 200-400 nanomètres. Les organoclays sont par exemple fabriquées en suivant le mode opératoire décrit dans la demande FR 2 925 359, la taille des éléments organoclays obtenus étant de 30 nanomètres environ. Ces éléments sont plats, présentent une face organique, et sont dispersables jusqu'à 30% en masse dans l'eau ou dans des solvants organiques, tel qu'un alcool, une cétone, un solvant chloré, ou un solvant fluoré, comme par exemple du perfluoro alkane/decane/hexane ou du perfluoro isobutène. La solution comportant les organoclays ainsi obtenue est ensuite chargée avec les particules anti-UV organiques, par exemple selon le mode opératoire décrit dans la demande FR 2 925 359, puis un liant, par exemple de l'acrylate, est ajouté. La composition obtenue est alors par exemple enduite par tournette ou au couteau.

De manière avantageuse, la composition comprend également un matériau qui bloque des longueurs d'onde visibles, par exemple un colorant, afin notamment de protéger les matériaux semi-conducteurs lors de forte émission dans le visible en raison de certaines techniques de gravure utilisées, notamment la gravure au plasma.

De manière avantageuse, des particules inorganiques, par exemple des particules de ZnO et/ou de pyrène, sont ajoutées à la composition afin de décaler le spectre d'absorption dans l'UV.

De manière avantageuse, un polystyrène, un pyrène ou un dérivé de ceux-ci, par exemple du latex de polystyrène et/ou de l'acide pyrène carboxylique, est ajouté à la matrice, afin d'inhiber un effet de surface photocatalytique des particules dispersées. En effet, les particules organiques anti-UV sont usuellement très sensibles à l'oxydation par le dioxygène et l'ozone. En outre, les particules d'oxyde peuvent, sous l'effet d'une photocatalyse, produire des radicaux libres susceptibles de réagir avec les matériaux semi-conducteurs organiques, et donc dégrader ces derniers. Aussi, si les gravures des couches de matériau semi-conducteur sont différées, sans mesure particulière, il existe un risque de voir les particules s'oxyder. De même, la mise en oeuvre d'un plasma, notamment lors d'une gravure au plasma, produit fréquemment de l'ozone, qui peut également dégrader lesdites particules. Un dérivé du pyrène ou de polystyrène permet donc de se prémunir d'un tel phénomène. Par exemple un dérivé du pyrène selon la formulation suivante, avec n = 1 à 4, peut être utilisé :

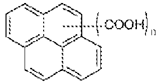

De manière avantageuse, les particules dispersées dans la matrice sont enrobées d'une coquille de silice, ce qui permet également d'éviter une photocatalyse de ces dernières. La coquille de silice permet également de formuler de manière aisée les particules via la chimie des agents de couplage silane. En encapsulant les particules, leur stabilité dans le mélange est augmentée et leur intégration est améliorée.

De manière avantageuse, les particules ont leurs dimensions comprises entre 1 nanomètre et 200 nanomètres, et de préférence entre 20 nanomètres et 30 nanomètres, et représentent 35% à 55% de la masse de la couche anti-ultraviolet, ce qui permet un dépôt aisé de la couche anti-UV. En limitant la taille des particules, on réduit ainsi le risque de formation d'agrégats et donc le risque de zones dépourvues de particules anti-UV qui ne protégeraient pas les matériaux semi-conducteurs. Par ailleurs, on choisissant un tel pourcentage en masse, la composition formée de la matrice et des particules dispersées se dépose aisément sous la forme d'un film et peut en outre se retirer facilement.

En variante, une dispersion colloïdale de ZnO est par exemple utilisée, où le ZnO représente 35% en masse et est dispersé dans un solvant organique, par exemple d'alcool ou de cétone, un tel sol colloïdal pouvant être formulé avec un liant organique, comme de l'acrylate par exemple, et déposé à la tournette ou au couteau sur la couche à protéger. De manière avantageuse, des nanoparticules de ZnO sous forme de palets de 30 nanomètres de diagonal au moins et de 20 nanomètres d'épaisseur, telles que celles commercialisées par les sociétés EVONIK et BYK sont utilisées. Les palets ont pour avantage de s'auto arranger sur le substrat pour former des couches continues.

La composition et/ou l'épaisseur des masques anti-UV sont avantageusement choisies en fonction du type de protection anti-UV souhaité pour le circuit CMOS.

Notamment, lorsque le circuit CMOS comprend dans sa forme finale les masques anti-UV **22** et **30,** l'épaisseur de ces derniers est choisie pour perturber au minimum le fonctionnement des transistors. Notamment, les masques **22, 30** et la couche de diélectrique **32** forment ensemble une couche isolante ayant pour fonction d'isoler les électrodes de grille des couches de matériaux semi-conducteurs. De préférence, l'épaisseur totale de matériau isolant entre une électrode de grille et le matériau semi-conducteur associé est inférieure à 1 micromètre. Au-delà, on observe une dégradation sensible des performances des transistors.

L'épaisseur des masques est en outre choisie en fonction de la quantité de rayonnements UV susceptible d'impacter les masques anti-UV. Notamment, lorsqu'une gravure au plasma est utilisée pour la fabrication des transistors, l'épaisseur des masques est choisie en fonction de la puissance du plasma. Avantageusement, une couche de polymère fluoré dans laquelle sont dispersées entre 45% et 55% en masse des particules de ZnO, dont l'épaisseur est comprise entre 50 et 200 nanomètres, permet de protéger efficacement du rayonnement UV généré par un plasma de puissance inférieure à 10 watts. De même, une épaisseur supérieure à 200 nanomètres permet de protéger efficacement contre une puissance de plasma comprise entre 10 watts et 50 watts, et une épaisseur supérieure au micromètre permet de protéger les matériaux semi-conducteurs contre des puissances de plasma supérieures à 50 watts.

Lorsque les masques anti-UV sont retirés, et ne font donc pas partie du circuit CMOS final, l'utilisateur possède plus de degrés de liberté pour le choix de la composition et de l'épaisseur desdits filtres. Le filtre peut ainsi présenter une épaisseur supérieure à 800 nanomètres, voire supérieure au micromètre, pour garantir une protection sensiblement totale contre les UV générés par des puissances importantes de plasma.

Bien entendu, d'autres types de gravure peuvent être utilisés, par exemple des gravures chimiques, pour éliminer le surplus de matériaux semi-conducteurs. Lorsque les masques anti-UV ont pour but de protéger contre les rayonnements UV uniquement, une épaisseur comprise entre 100 nanomètres et 200 nanomètres permet une protection efficace.

## Revendications

1. Circuit CMOS organique comprenant un substrat (10) sur lequel sont formés un transistor organique de type N (14, 16, 24, 32, 34) et un transistor organique de type P (16, 18, 30, 32, 36), lesdits transistors comportant respectivement une couche de matériau semi-conducteur de type N (24) et une couche de matériau semi-conducteur de type P (30), ***caractérisé* en ce qu'**une face de chacune des couches semi-conducteur (24, 30), opposée au substrat (10), est recouverte d'une couche anti-ultraviolet (22, 28) constituée de matériau électriquement isolant absorbant et/ou réfléchissant les rayonnements ultra-violets, la couche anti-ultraviolet (22, 28) étant au contact direct de la couche semi-conducteur (24, 30).

2. Circuit CMOS organique selon la revendication 1, ***caractérisé* en ce que** les couches anti-ultraviolet (22, 28) comprennent une matrice organique dans laquelle sont dispersées des particules de ZnO, de TiO₂, de CeO₂ et/ou d'organoclay.

3. Circuit CMOS selon la revendication 2, ***caractérisé* en ce que** les particules sont enrobées de silice.

4. Circuit CMOS selon la revendication 2 ou 3, ***caractérisé* en ce que** les particules ont leurs dimensions comprises entre 1 nanomètre et 200 nanomètres, et de préférence entre 20 nanomètres et 30 nanomètres.

5. Circuit CMOS selon la revendication 2, 3 ou 4, ***caractérisé* en ce que** les particules représentent 45% à 55% de la masse de la couche anti-ultraviolet.

6. Circuit CMOS selon l'une quelconque des revendications précédentes, ***caractérisé* en ce que** les couches anti-ultraviolet (22, 28) comprennent du latex de polystyrène et/ou l'acide pyrène carboxylique.

7. Circuit CMOS selon l'une quelconque des revendications précédentes, ***caractérisé* en ce que** les couches anti-ultraviolet (22, 28) ont une épaisseur comprise entre 50 nanomètres et 800 nanomètres, et de préférence entre 100 nanomètres et 200 nanomètres.

8. Circuit CMOS selon l'une quelconque des revendications précédentes, ***caractérisé* en ce que** chaque transistor comprend une couche de matériau diélectrique (32) intercalée entre la couche anti-ultraviolet (22, 28) recouvrant la couche de matériau semi-conducteur (24, 30) du transistor et une électrode de grille (34, 36) du transistor, et **en ce que** l'épaisseur totale de la couche diélectrique (32) et de la couche anti-ultraviolet (22, 28) du transistor est inférieure à 1 micromètre.

9. Circuit CMOS selon l'une quelconque des revendications précédentes, ***caractérisé* en ce que** la couche anti-ultraviolet (22, 28) ne recouvre sensiblement que la couche semi-conducteur (24, 30).

10. Circuit CMOS selon l'une quelconque des revendications précédentes, ***caractérisé* en ce que** les transistors comprennent des électrodes de grille transparente au rayonnement visible.

11. Procédé de fabrication d'un circuit CMOS organique comprenant un substrat (10) sur lequel sont formés un transistor organique de type N (14, 16, 24, 32, 34) et un transistor organique de type P (16, 18, 30, 32, 36), le procédé comportant :
▪ la réalisation de première, deuxième et troisième électrodes conductrices distinctes (14, 16, 18) sur une face d'un support (10);
▪ le dépôt sur l'ensemble de la face du support (10) d'une première couche de matériau semi-conducteur organique (20) d'un premier type de conductivité ;
▪ le retrait partiel de la première couche de matériau semi-conducteur (20) de manière à conserver uniquement une première portion (24) de matériau semi-conducteur recouvrant au moins partiellement la première électrode (14), au moins partiellement la deuxième électrode (16) et une zone de la face du support (10) reliant les première et deuxième électrodes (14, 16) ;
▪ le dépôt sur l'ensemble de la face du support (10) d'une seconde couche de matériau semi-conducteur organique (26) d'un second type de conductivité, opposé au premier type de conductivité ;
▪ le retrait partiel de la seconde couche de matériau semi-conducteur (26) de manière à conserver uniquement une seconde portion (30) recouvrant au moins partiellement la deuxième électrode (16), au moins partiellement la troisième électrode (18) et une zone de la face du support (10) reliant les deuxième et troisième électrodes (16, 18);
***caractérisé* en ce que** :
▪ préalablement au retrait partiel de la première couche de matériau semi-conducteur (20), une couche anti-ultraviolet (22) constituée de matériau électriquement isolant absorbant et/ou réfléchissant les rayonnements ultra-violets est déposée directement sur la première portion (24) de matériau semi-conducteur ; et
▪ préalablement au retrait partiel de la seconde couche de matériau semi-conducteur (26), une couche anti-ultraviolet (28) constituée de matériau électriquement isolant absorbant et/ou réfléchissant les rayonnements ultra-violets est déposée directement sur la seconde portion (30) de matériau semi-conducteur.

12. Procédé de fabrication d'un circuit CMOS organique selon la revendication 11, ***caractérisé* en ce que** les couches anti-ultraviolet (22, 28) comprennent une matrice organique dans laquelle sont dispersées des particules de ZnO, de TiO₂, de CeO₂ et/ou d'organoclay.

13. Procédé de fabrication d'un circuit CMOS organique selon la revendication 12, ***caractérisé* en ce que** les particules sont enrobées de silice.

14. Procédé de fabrication d'un circuit CMOS organique selon la revendication 12 ou 13, ***caractérisé* en ce que** les particules ont leurs dimensions comprises entre 1 nanomètre et 200 nanomètres, et de préférence entre 20 nanomètres et 30 nanomètres.

15. Procédé de fabrication d'un circuit CMOS organique selon la revendication 12, 13 ou 14, ***caractérisé* en ce que** les particules représentent 45% à 55% de la masse de la couche anti-ultraviolet.

16. Procédé de fabrication d'un circuit CMOS organique selon l'une quelconque des revendications 12 à 15, ***caractérisé* en ce que** la matrice organique est constitué d'un polymère fluoré, notamment de CYTOP.

17. Procédé de fabrication d'un circuit CMOS organique selon l'une quelconque des revendications 11 à 16, ***caractérisé* en ce que** les couches anti-ultraviolet (22, 28) comprennent du latex de polystyrène et/ou l'acide pyrène carboxylique.

18. Procédé de fabrication d'un circuit CMOS organique selon l'une quelconque des revendications 11 à 17, ***caractérisé* en ce que** les couches anti-ultraviolet (22, 28) ont une épaisseur comprise entre 50 nanomètres et 800 nanomètres, et de préférence entre 100 nanomètres et 200 nanomètres.

19. Procédé de fabrication d'un circuit CMOS organique selon l'une quelconque des revendications 11 à 17, ***caractérisé* en ce que** les couches anti-ultraviolet (22, 28) ont une épaisseur supérieure à 800 nanomètres, et **en ce que** les couches anti-ultraviolets sont ôtées après la finalisation des première et deuxième portions de matériau semi-conducteur.

20. Procédé de fabrication d'un circuit CMOS organique selon l'une quelconques des revendications 11 à 19, ***caractérisé* en ce que** les retraits partiels des couches de matériau semi-conducteur (20, 26) sont réalisés au moyen d'une gravure au plasma.

## Patentansprüche

1. Organische CMOS-Schaltung, die ein Substrat (10) umfasst, auf dem ein organischer N-Typ-Transistor (14, 16, 24, 32, 34) und ein organischer P-Typ-Transistor (16, 18, 30, 32, 36) ausgebildet sind, diese Transistoren umfassen jeweils eine Schicht N-Typ-Halbleitermaterial (24) und eine Schicht aus P-Typ-Halbleitermaterial (30), **dadurch gekennzeichnet, dass** eine Fläche jeder der Schichten aus Halbleitermaterial (24, 30), entgegengesetzt zum Substrat (10) mit einer UV-Schutzschicht (22, 28) bedeckt ist, die aus einem elektrisch isolierenden Material besteht, das Ultraviolettstrahlung absorbiert und/ oder reflektiert, die UV-Schutzschicht (22, 28) hat dabei direkten Kontakt mit der Halbleiterschicht (24, 30).

2. Organische CMOS-Schaltung nach Anspruch 1, **dadurch gekennzeichnet, dass**, die UV-Schutzschichten (22, 28) eine organische Matrix enthalten, in der ZnO-, TiO₂-, CeO₂ und/ oder Schichtsilikat-Teilchen dispergiert sind.

3. CMOS-Schaltung nach Anspruch 2, **dadurch gekennzeichnet, dass**, die Teilchen mit Siliziumoxid umhüllt sind.

4. CMOS-Schaltung nach Anspruch 2 oder 3, **dadurch gekennzeichnet, dass** die Abmessungen der Teilchen zwischen 1 Nanometer und 200 Nanometern liegen, am besten zwischen 20 Nanometern und 30 Nanometern.

5. CMOS-Schaltung nach Anspruch 2, 3 oder 4, **dadurch gekennzeichnet, dass** die Abmessungen der Teilchen 45% bis 55% der Masse der UV-Schutzschicht darstellen.

6. CMOS-Schaltung nach einem der vorhergehenden Ansprüche, **dadurch gekennzeichnet, dass** die UV-Schutzschichten (22, 28) Polystyrol-Latex und/ oder Pyrencarbonsäure enthalten.

7. CMOS-Schaltung nach einem der vorhergehenden Ansprüche, **dadurch gekennzeichnet, dass** die UV-Schutzschichten (22, 28) eine Dicke zwischen 50 Nanometern und 800 Nanometern, am besten zwischen 100 Nanometern und 200 Nanometern, haben.

8. CMOS-Schaltung nach einem der vorhergehenden Ansprüche, **dadurch gekennzeichnet, dass** jeder Transistor eine Schicht dielektrisches Material (32) enthält; aufgebracht zwischen der UV-Schutzschicht (22, 28), die die Halbleiterschicht (24, 30) des Transistors bedeckt und einer Gate-Elektrode (34, 36) des Transistors und dadurch dass, die Gesamtdicke der dielektrischen Schicht (32) der UV-Schutzschicht (22, 28) des Transistors kleiner ist als 1 Mikrometer.

9. CMOS-Schaltung nach einem der vorhergehenden Ansprüche, **dadurch gekennzeichnet, dass** die UV-Schutzschicht (22, 28) im Wesentlichen nur die Halbleiterschicht (24, 30) bedeckt.

10. CMOS-Schaltung nach einem der vorhergehenden Ansprüche, **dadurch gekennzeichnet, dass** die Transistoren für sichtbare Strahlung durchlässige Gate-Elektroden enthalten.

11. Verfahren zur Herstellung einer organischen CMOS-Schaltung, die ein Substrat (10) umfasst, auf dem ein organischer N-Typ-Transistor (14, 16, 24, 32, 34) und ein organischer P-Typ-Transistor (16, 18, 30, 32, 36) ausgebildet sind, dieses Verfahren umfasst:
▪ die Herstellung von voneinander getrennten ersten, zweiten und dritten leitenden Elektrode (14, 16, 18) auf einer Fläche des Trägers (10);
▪ Ablagerung auf der gesamten Fläche des Trägers (10) einer ersten Schicht organischen Halbleitermaterials (20) mit einem ersten Leitfähtigkeitstyp;
▪ die teilweise Entfernung der ersten Schicht organischen Halbleitermaterials (20), so dass nur ein erster Teilabschnitt (24) des Halbleitermaterials beibehalten wird, der mindestens teilweise die erste Elektrode (14) abdeckt, mindestens teilweise die zweite Elektrode (16) und einen Bereich der Fläche des Trägers (10), die die erste und zweite Elektrode (14, 16) miteinander verbindet;
▪ Ablagerung auf der gesamten Fläche des Trägers (10) einer zweiten Schicht organischen Halbleitermaterials (26) mit einem zweiten Leitfähtigkeitstyp, entgegengesetzt zum ersten Leitfähigkeitstyp;
▪ die teilweise Entfernung der zweiten Schicht organischen Halbleitermaterials (26), so dass nur ein zweiter Teilabschnitt (30) des Halbleitermaterials beibehalten wird, der mindestens teilweise die zweite Elektrode (16) abdeckt, mindestens teilweise die dritte Elektrode (18) und einen Bereich der Fläche des Trägers (10), die die zweite und dritte Elektrode (16, 18) miteinander verbindet;
**dadurch gekennzeichnet, dass**:
▪ vor der teilweisen Entfernung der ersten Halbleitermaterialschicht (20) eine UV-Schutzschicht (22) aufgebracht wird, bestehend aus elektrisch isolierendem Material das UV-Strahlen absorbiert und/ oder reflektiert, direkt auf dem ersten Abschnitt (24) des Halbleitermaterials abgelagert wird, und
▪ vor der teilweisen Entfernung der zweiten Halbleitermaterialschicht (26) eine UV-Schutzschicht (28) aufgebracht wird, bestehend aus elektrisch isolierendem Material das UV-Strahlen absorbiert und/ oder reflektiert, direkt auf dem zweiten Abschnitt (30) des Halbleitermaterials abgelagert wird.

12. Verfahren zur Herstellung einer organischen CMOS-Schaltung gemäß Anspruch 11, **dadurch gekennzeichnet, dass** die UV-Schutzschichten (22, 28) eine organische Matrix enthalten, in der ZnO-, TiO₂-, CeO₂ und/ oder Schichtsilikat-Teilchen dispergiert sind.

13. Verfahren zur Herstellung einer organischen CMOS-Schaltung gemäß Anspruch 12, **dadurch gekennzeichnet, dass** die Teilchen mit Siliziumoxid umhüllt sind.

14. Verfahren zur Herstellung einer organischen CMOS-Schaltung gemäß Anspruch 12 oder 13, **dadurch gekennzeichnet, dass** die Abmessungen der Teilchen zwischen 1 Nanometer und 200 Nanometern liegen, am besten zwischen 20 Nanometern und 30 Nanometern.

15. Verfahren zur Herstellung einer organischen CMOS-Schaltung gemäß Anspruch 12, 13, oder 14, **dadurch gekennzeichnet, dass** die Teilchen 45% bis 55% der Masse der UV-Schutzschicht darstellen.

16. Verfahren zur Herstellung einer organischen CMOS-Schaltung nach einem der Ansprüche 12 bis 15, **dadurch gekennzeichnet, dass** die organische Matrix aus einem fluorierten Polymer besteht, insbesondere CYTOP.

17. Verfahren zur Herstellung einer organischen CMOS-Schaltung nach einem der Ansprüche 11 bis 16, **dadurch gekennzeichnet, dass** UV-Schutzschichten (22, 28) Polystyrol-Latex und/ oder Pyrencarbonsäure enthalten.

18. Verfahren zur Herstellung einer organischen CMOS-Schaltung nach einem der Ansprüche 11 bis 17, **dadurch gekennzeichnet, dass** die UV-Schutzschichten (22, 28) eine Dicke zwischen 50 Nanometern und 800 Nanometern, am besten zwischen 100 Nanometern und 200 Nanometern haben.

19. Verfahren zur Herstellung einer organischen CMOS-Schaltung nach einem der Ansprüche 11 bis 17, **dadurch gekennzeichnet, dass** die UV-Schutzschichten (22, 28) eine Dicke von mehr als 800 Nanometern haben und dass die UV-Schutzschichten nach der Fertigstellung des ersten und zweiten Abschnitts des Halbleitermaterials entfernt werden.

20. Verfahren zur Herstellung einer organischen CMOS-Schaltung nach einem der Anspruche 11 bis 19, **dadurch gekennzeichnet, dass** die teilweise Entfernung des Halbleitermaterials (20, 26) mittels Plasmaätzen erfolgt.

## Claims

1. An organic CMOS circuit comprising a substrate (10) having an N-type organic transistor (14, 16, 24, 32, 34) and a P-type organic transistor (16, 18, 30, 32, 36) formed therein, said transistors respectively comprising a layer (24) of N-type semiconductor material and a layer (30) of P-type semiconductor material, wherein a surface of each of the semiconductor layers (24, 30), opposite to the substrate (10), is covered with an anti-ultraviolet layer (22, 28) made of electrically-insulating material absorbing and/or reflecting ultraviolet rays, the anti-ultraviolet layer (22, 28) being in direct contact with the semiconductor layer (24, 30).

2. The organic CMOS circuit of claim 1, wherein the anti-ultraviolet layers (22, 28) comprise an organic matrix having ZnO, TiO₂, CeO₂, and/or organoclay particles dispersed therein.

3. The CMOS circuit of claim 2, wherein the particles are coated with silica.

4. The CMOS circuit of claim 2 or 3, wherein the particles have their dimensions in the range from 1 nanometer to 200 nanometers, and preferably from 20 nanometers to 30 nanometers.

5. The CMOS circuit of claim 2, 3 or 4, wherein the particles amount to from 45% to 55% of the mass of the anti-ultraviolet layer.

6. The CMOS circuit of any of the preceding claims, wherein the anti-ultraviolet layers (22, 28) comprise polystyrene latex and/or pyrene carboxylic acid.

7. The CMOS circuit of any of the preceding claims, wherein the anti-ultraviolet layers (22, 28) have a thickness in the range from 50 nanometers to 800 nanometers, and preferably from 100 nanometers to 200 nanometers.

8. The CMOS circuit of any of the preceding claims, wherein each transistor comprises a layer of dielectric material (32) interposed between the anti-ultraviolet layer (22, 28) covering the layer (24, 30) of semiconductor material of the transistor and a gate electrode (34, 36) of the transistor, and wherein the total thickness of the dielectric layer (32) and of the anti-ultraviolet layer (22, 28) of the transistor is smaller than 1 micrometer.

9. The CMOS circuit of any of the preceding claims, wherein the anti-ultraviolet layer (22, 28) only substantially covers the semiconductor layer (24, 30).

10. The CMOS circuit of any of the preceding claims, wherein the transistors comprise gate electrodes transparent to the visible radiation.

11. A method of manufacturing an organic CMOS circuit comprising a substrate (10) having an N-type organic transistor (14, 16, 24, 32, 34) and a P-type organic transistor (16, 18, 30, 32, 36) formed thereon, the method comprising:
▪ forming first, second, and third separate conductive electrodes (14, 16, 18) on a surface of a support (10);
▪ depositing over the entire surface of the support (10) a first layer (20) of organic semiconductor material of a first conductivity type;
▪ partially removing the first layer (20) of semiconductor material to only keep a first portion (24) of semiconductor material at least partially covering the first electrode (14), at least partially covering the second electrode (16), and covering an area of the surface of the support (10) connecting the first and second electrodes (14, 16);
▪ depositing over the entire surface of the support (10) a second layer (26) of an organic semiconductor material of a second conductivity type, opposite to the first conductivity type;
▪ partially removing the second layer (26) of semiconductor material to only keep a second portion (30) at least partially covering the second electrode (16), at least partially covering the third electrode (18), and covering an area of the surface of the support (10) connecting the second and third electrodes (16, 18);
▪ wherein prior to the partial removal of the first layer (20) of semiconductor material, an anti-ultraviolet layer (22) made of an electrically-insulating material absorbing and/or reflecting ultraviolet rays is deposited directly on the first portion (24) of semiconductor material; and
▪ wherein prior to the partial removal of the second layer (26) of semiconductor material, an anti-ultraviolet layer (28) made of electrically-insulating material absorbing and/or reflecting ultraviolet rays is deposited directly on the second portion (30) of semiconductor material.

12. A method of manufacturing the organic CMOS circuit of claim 11, wherein the anti-ultraviolet layers (22, 28) comprise an organic matrix having ZnO, TiO₂, CeO₂, and/or organoclay particles.

13. The organic CMOS circuit manufacturing method of claim 12, wherein the particles are coated with silica.

14. The organic CMOS circuit manufacturing method of claim 12 or 13, wherein the particles have their dimensions in the range from 1 nanometer to 200 nanometers, and preferably from 20 nanometers to 30 nanometers.

15. The organic CMOS circuit manufacturing method of claim 12, 13 or 14, wherein the particles amount to from 45% to 55% of the mass of the anti-ultraviolet layer.

16. The organic CMOS circuit manufacturing method of any of claims 12 to 15, wherein the organic matrix is made of a fluorinated polymer, particularly CYTOP.

17. The organic CMOS circuit manufacturing method of any of claims 11 to 16, wherein the anti-ultraviolet layers (22, 28) comprise polystyrene latex and/or pyrene carboxylic acid.

18. The organic CMOS circuit manufacturing method of any of claims 11 to 17, wherein the anti-ultraviolet layers (22, 28) have a thickness in the range from 50 nanometers to 800 nanometers, and preferably from 100 nanometers to 200 nanometers.

19. The organic CMOS circuit manufacturing method of any of claims 11 to 17, wherein the anti-ultraviolet layers (22, 28) have a thickness greater than 800 nanometers, and wherein the anti-ultraviolet layers are removed after the completion of the first and second portions of semiconductor material.

20. The organic CMOS circuit manufacturing method of any of claims 11 to 19, wherein the partial removals of the layers (20, 26) of semiconductor material are performed by means of a plasma etching.
